# DEMANDE DE BREVET EUROPEEN

(11) **EP 2 145 979 A1**
(43) Date de publication de la demande: **20.01.2010**
(21) Numéro de dépôt: 08160508.1
(22) Date de dépôt: 16.07.2008
(51) Int. Cl.: C23C 16/509, C23C 16/54, C03C 17/00

(54) **Procédé et installation pour le dépôt de couches sur les deux faces d'un substrat de façon simultanée**

(71) Demandeur: AGC Flat Glass Europe SA, 1170 Bruxelles (BE)
(72) Inventeur: La désignation de l'inventeur n'a pas encore été déposée
(74) Mandataire: Vandeberg, Marie-Paule L.G.

(57) **Abrégé**

Un procédé pour le dépôt simultané de couches sur les deux faces d'un substrat (2) qui comprend notamment l'introduction ou le défilement d'un substrat (2) dans une chambre de réaction (106, 206) dans laquelle sont placées au moins deux électrodes (110, 210). Au moins une barrière diélectrique (14, 114) est placée entre ces au moins deux électrodes (110, 210). On engendre une tension électrique à haute fréquence de valeur telle qu'elle entraîne la génération d'un plasma (112, 212) de part et d'autre du substrat entre les au moins deux électrodes (110, 210). On introduit dans la chambre de réaction (106, 206), de part et d'autre du substrat, un mélange (108, 208) dont la composition est telle qu'au contact du plasma, il se décompose et engendre des espèces aptes à se déposer en couches sur les faces correspondantes du substrat. On maintient le substrat (2) dans la chambre durant un laps de temps suffisant pour obtenir sur chacune de ses faces une couche d'une épaisseur souhaitée.

## Description

### Domaine de l'invention

L'invention se rapporte à un procédé pour le dépôt de couches sur les deux faces d'un substrat de façon simultanée afin d'en modifier les propriétés. En particulier, l'invention vise le dépôt simultané de couches sur des plaques de verre

L'invention se rapporte aussi à une installation permettant d'appliquer le procédé en question, notamment en continu.

### État de la technique

Différents procédés sont utilisés pour déposer des revêtements en couches minces sur une des faces de substrats divers. Ils se différencient notamment par la façon dont l'énergie est engendrée pour la production et/ou la liaison au support des composés souhaités.

Les dépôts de revêtements en couches minces touchent diverses applications, comme l'électronique, les revêtements anti-corrosion et tribologiques tels que les couches réfractaires (nitrures, carbures et oxydes de titane ou d'aluminium), les revêtements à propriétés optiques (anti-réfléchissants, anti-solaires, filtres, ..), les revêtements procurant d'autres propriétés de surface particulières(anti-microbienne,auto-nettoyante, hydrophile, hydrophobe, ...), les couches d'oxyde d'étain conductrices pour applications diverses (photovoltaïques, LED, OLED, organique photovoltaïque...).

Les substrats concernés peuvent être de divers types : verre, acier, céramique, polymères organiques, thermoplastiques...

On distingue principalement quatre techniques de dépôt de couches minces applicables en particulier dans le domaine verrier : le sol-gel, le magnétron, le spray pyrolytique, et la CVD (Chemical Vapor Déposition).

La CVD consiste à envoyer, sur un substrat chaud, des réactifs chimiques ou précurseurs, préalablement vaporisés et qui se décomposent par pyrolyse au contact du substrat chaud.

Ce procédé est couramment appliqué « on-line » lors de la production du verre flotté.

On obtient ainsi des couches minces (de l'ordre de quelques dizaines ou centaines de nm), notamment d'oxydes. Les couches obtenues sont denses, d'une grande pureté et généralement très stables chimiquement ainsi que mécaniquement. Les vitesses de dépôt sont élevées.

Cependant, la gamme de matériaux pouvant être déposés est limitée car il est difficile de trouver des précurseurs volatilisables et qui vont pyrolyser dans la gamme de températures accessibles aux verriers (500-750°C).

Une possibilité de s'affranchir de la température du substrat et donc d'élargir la gamme des précurseurs utilisables en CVD et, par conséquent, la gamme de matériaux déposables, est de combiner la CVD classique (éventuellement à plus basse température) avec un dispositif plasma.

La PECVD (pour « Plasma Enhanced Chemical Vapour Déposition ») peut s'effectuer à l'aide de n'importe quel plasma : plasmas froids (hors équilibre) ou plasmas thermiques (en équilibre).

Les plasmas froids sont généralement préférés. Les espèces actives du plasma (électrons, ions, métastables,...) possèdent typiquement des énergies de plusieurs eV et peuvent ainsi provoquer la dissociation ou l'activation des précurseurs chimiques

Pour maintenir le plasma hors équilibre, il est souvent nécessaire de travailler à pression réduite. La plupart des techniques connues de PECVD utilisent donc des plasmas à basse pression.

Cependant, pour appliquer ce procédé à des fins industrielles, il est nécessaire de minimiser les coûts. Il y a donc un intérêt croissant de la part des industriels pour transférer les technologies plasma basses pressions vers des technologies plasma fonctionnant dans une gamme de pression proche de la pression atmosphérique.

On a cherché à allier les potentialités des procédés de traitement par CVD classique avec les potentialités d'un procédé plasma à pression atmosphérique. Notre choix s'est porté sur l'utilisation d'une décharge à barrière diélectrique (DBD). Cette dernière a en effet l'avantage, par rapport aux autres procédés plasma, de fonctionner tant à basse pression qu'à pression atmosphérique et de permettre un traitement continu sur de grandes surfaces.

Un tel procédé est décrit notamment dans WO 2005/113856 pour le revêtement de matière plastique. WO 2004/013376 décrit quant à lui un procédé CVD plasma, spécifique pour le dépôt de couches de TiO2 photocatalytique. Ce procédé nécessite un post-traitement par « glow discharge plasma » du revêtement déposé.

Dans les deux cas cités, les procédés présentent l'inconvénient majeur d'un rendement énergétique médiocre : une grande partie de la puissance engendrée est dissipée en pure perte. Le problème est lié en grande partie à l'impédance capacitive du circuit de décharge, qui est d'autant plus élevée que la distance entre les électrodes (et par conséquent la distance entre les électrodes et un substrat placé entre celles-ci) est grande.

### Résumé de l'invention

On a pensé à placer un substrat entre deux électrodes tout en maintenant un intervalle de part et d'autre du substrat pour créer deux zones de réaction, de façon à réaliser un dépôt de couche simultanément sur les deux faces d'un substrat.

Un premier but de l'invention est de gagner du temps en réalisant un dépôt de couches, éventuellement de natures différentes, simultanément sur les deux faces d'un substrat.

Un autre but de l'invention est d'améliorer le rendement d'une installation de dépôt de couches sur un substrat utilisant le procédé DBD

Un autre but de l'invention est que cette amélioration conserve son efficacité quelles que soient les conditions imposées par différents types de fabrications, et notamment pour des substrats de différentes épaisseurs, pour des natures de couches différentes, etc.

L'objet de l'invention est un procédé pour le dépôt simultané sur les deux faces d'un substrat **caractérisé en ce qu**'il comprend les opérations suivantes :
- introduire ou faire défiler un substrat dans une chambre de réaction dans laquelle sont placées, de part et d'autre du substrat, au moins deux électrodes ; au moins une barrière diélectrique est placée entre au moins une des faces de substrat et ces au moins deux électrodes;
- engendrer une tension électrique à haute fréquence de valeur telle qu'elle entraîne la génération d'un plasma de part et d'autre du substrat entre les au moins deux électrodes;
- introduire dans la chambre de réaction, de part et d'autre du substrat, des mélanges dont les compositions sont telles qu'au contact du plasma, ils se décomposent et engendrent des espèces aptes à se déposer en couche sur la face correspondante du substrat ;
- maintenir le substrat dans la chambre durant un laps de temps suffisant pour obtenir sur chacune de ses faces une couche d'une épaisseur souhaitée.

On notera que le procédé de l'invention est défini en termes d' « opérations » plutôt que d' « étapes », c'est à dire que la succession des opérations ne s'effectue pas obligatoirement dans l'ordre où elles sont énoncées ci-dessus.

Un premier avantage du procédé de l'invention est que l'énergie apportée par le plasma de part et d'autre du substrat peut être modulée notamment en ajustant les distances respectives entre les électrodes et le substrat, ce qui rend possible le dépôt simultané de couches d'une grande variété de compositions.

Suivant un mode de réalisation avantageux, la composition des mélanges introduits dans la chambre de réaction, de part et d'autre du substrat, est identique. En respectant le principe de symétrie, on facilite évidemment les réglages et on réduit les problèmes d'interférences entre les différents réactifs. On réalise dans ce cas à la fois un gain de temps et de place lors de la fabrication.

Suivant un autre mode de réalisation avantageux, la composition des mélanges introduits dans la chambre de réaction, de part et d'autre du substrat, est différente. Ceci permet d'engendrer des espèces aptes à se déposer en couches différentes sur la face correspondante du substrat. On réalise dans ce cas à la fois un gain de temps et de place lors de la fabrication.

Suivant un mode de réalisation avantageux, les mélanges introduits dans la chambre de réaction de part et d'autre du substrat sont confinés dans deux zones distinctes par des barrières mécaniques. Le substrat lui-même peut faire partie de ces barrières mécaniques.

Suivant un autre mode de réalisation avantageux, éventuellement complémentaire au précédent, les mélanges introduits dans la chambre de réaction de part et d'autre du substrat sont confinés dans deux zones distinctes par des dispositifs d'aspiration et/ou de refoulement.

Suivant un mode de réalisation préféré, le procédé comprend en outre les opérations suivantes :
- mettre en service une inductance ajustable (L) disposée en parallèle avec l'inductance propre de l'installation engendrant la tension électrique, de façon à réduire le déphasage entre la tension et le courant engendré ;
- adapter la tension et/ou la fréquence fournies par le circuit générateur et/ou la valeur de l'inductance ajustable (L) au début ou en cours de procédé, de façon à obtenir des caractéristiques de réaction optimales ;

Un avantage de cette variante est que l'introduction d'une inductance dans le circuit améliore le facteur de puissance de l'installation, d'où un accroissement considérable de son rendement. Un autre avantage de cette variante est qu'elle permet également au procédé de générer suffisamment d'énergie active pour obtenir des taux de dépôt élevés tout en améliorant les propriétés des couches déposées.

Suivant un mode de réalisation préféré, on module la tension et/ou la fréquence fournies par le circuit générateur et/ou la valeur de l'inductance de façon à favoriser la production d'harmoniques prolongeant le temps durant lequel la tension reste supérieure à la valeur de maintien de l'arc, ce qui a pour conséquence la prolongation du temps de génération du plasma. L'on favorise de préférence les harmoniques d'ordre 3 et 5.

Un avantage de ce mode de réalisation est qu'à puissance consommée égale, l'efficacité du procédé est fortement améliorée.

Suivant un mode de réalisation avantageux, le procédé comprend en outre l'opération suivante : faire varier la position et/ou la configuration des électrodes de façon à obtenir des caractéristiques de réaction optimales. En effet, ces critères font varier les caractéristiques du circuit électrique et ils ont donc une influence sur la configuration du courant.

Suivant un mode de réalisation avantageux, le procédé comprend en outre l'opération suivante : - amener l'atmosphère régnant dans la chambre à une pression déterminée.

De façon avantageuse, le substrat est isolant et forme lui-même une des barrières diélectriques placées entre les au moins deux électrodes.

Par ailleurs, si le substrat est conducteur, il peut constituer lui-même une des électrodes.

Le mélange est introduit dans la chambre de réaction de préférence sous forme d'un liquide par spray, d'un gaz ou d'une poudre réactifs.

Un autre objet de l'invention est une installation de dépôt d'une couche sur un substrat comprenant une chambre, des moyens de transport et des moyens de support pour introduire ou faire défiler un substrat dans la chambre. Une alimentation électrique à haute tension et à haute fréquence est reliée à au moins deux électrodes disposées de part et d'autre du substrat et au moins une barrière diélectrique est disposée entre les au moins deux électrodes. Des moyens de régulation et de contrôle de l'alimentation électrique sont prévus, de même que des moyens d'introduction de substances réactives dans la chambre et des moyens d'extraction de gaz résiduels.

Suivant un mode de réalisation préféré, une inductance ajustable est placée en parallèle avec le circuit d'alimentation. Les caractéristiques de cette inductance ajustable sont telles qu'elle permet de moduler le déphasage entre la tension générée entre les électrodes et le courant total fourni par la source haute tension.

Dans cette installation, les moyens de régulation de l'alimentation électrique et les moyens de contrôle de l'inductance sont avantageusement couplés de façon à permettre la génération d'harmoniques prolongeant le maintien de la valeur de la tension entre les électrodes à une valeur supérieure à celle de maintien de la décharge électrique.

Suivant un mode de réalisation avantageux, la chambre est ouverte à ses deux extrémités, ce qui permet d'intégrer le procédé de dépôt dans une installation de production en continu, la chambre peut exemple être avantageusement intégrée dans une galerie de recuisson d'une ligne de production de verre flotté. Les moyens de support du substrat comprenant au moins un rouleau.

Suivant un mode de réalisation avantageux, la chambre est ouverte à ses deux extrémités et peut avantageusement être intégrée dans une d'une ligne de production en discontinu. La chambre peut par exemple être avantageusement intégrée dans une ligne de trempe de verre. Les moyens de support du substrat comprenant au moins un rouleau.

Suivant un autre mode de réalisation préféré, la chambre est fermée ce qui permet au procédé de l'invention de s'intégrer dans une opération de traitement de surface en discontinu. La chambre peut être placée par exemple sur des lignes de traitement type « sputtering magnétron ».

Un autre objet de l'invention est une inductance de déphasage pour l'installation de l'invention. Cette inductance comprend un bobinage constitué d'un faisceau d'éléments conducteurs isolés les uns par rapport aux autres, enroulé autour d'un mandrin; un noyau magnétique plongeur disposé à l'intérieur de ce mandrin, isolé de ce mandrin, divisé en plusieurs tronçons par des pastilles isolantes; un dispositif de positionnement relié au noyau plongeur; une connexion isolante reliant le noyau plongeur et le dispositif de positionnement ; un système de contrôle apte à agir sur le dispositif de positionnement, de façon à ajuster la position du noyau magnétique plongeur par rapport au mandrin.

### Brève description des figures

D'autres avantages et particularités de l'invention ressortiront de la description détaillée ci-après de modes de réalisation particuliers de l'invention, référence étant faite aux figures, dans lesquelles :
La Fig.1 est une vue schématique en élévation, d'une installation fermée pour le dépôt de couche sur un substrat en verre ;
La Fig.2 est un schéma électrique équivalent de l'installation de la Fig. 1 avant la formation de plasma;
La Fig.3 est un schéma électrique équivalent de l'installation de la Fig. 1 après la génération de plasma;
La Fig. 4 est un schéma électrique équivalent de l'installation suivant un mode de réalisation préféré de l'invention ;
La Fig. 5 est un oscillogramme tension/courant dans une installation classique
La Fig. 6 est un oscillogramme tension/courant obtenu grâce au procédé de l'invention ;
La Fig.7 est une vue schématique en élévation, d'une variante d'une installation ouverte à ses deux extrémités pour le dépôt de couche sur un substrat en verre suivant l'invention ;
La Fig. 8 est une vue schématique en élévation, d'une variante d'une installation dans le cas d'un substrat isolant. Le substrat, dans les conditions qui prévalent dans la chambre de dépôt, peut former lui-même une barrière diélectrique, ce qui nous donne la possibilité de ne pas utiliser une barrière diélectrique supplémentaire.
La Fig. 9 est une vue schématique en élévation d'une bobine de self pour une installation suivant l'invention. Les figures ne sont pas forcément dessinées à l'échelle.
La Fig. 10 est une vue en coupe d'un toron du fil de bobinage utilisé dans la self représentée à la Fig.9. Généralement, des éléments semblables sont dénotés par des références semblables dans les figures.

### Description détaillée de modes de réalisation particuliers

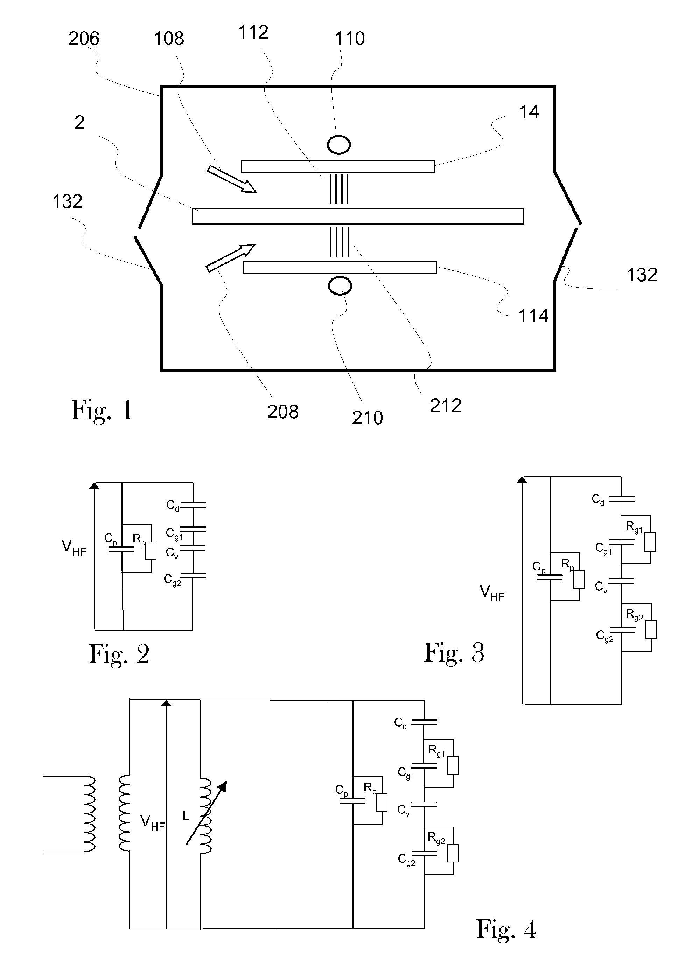

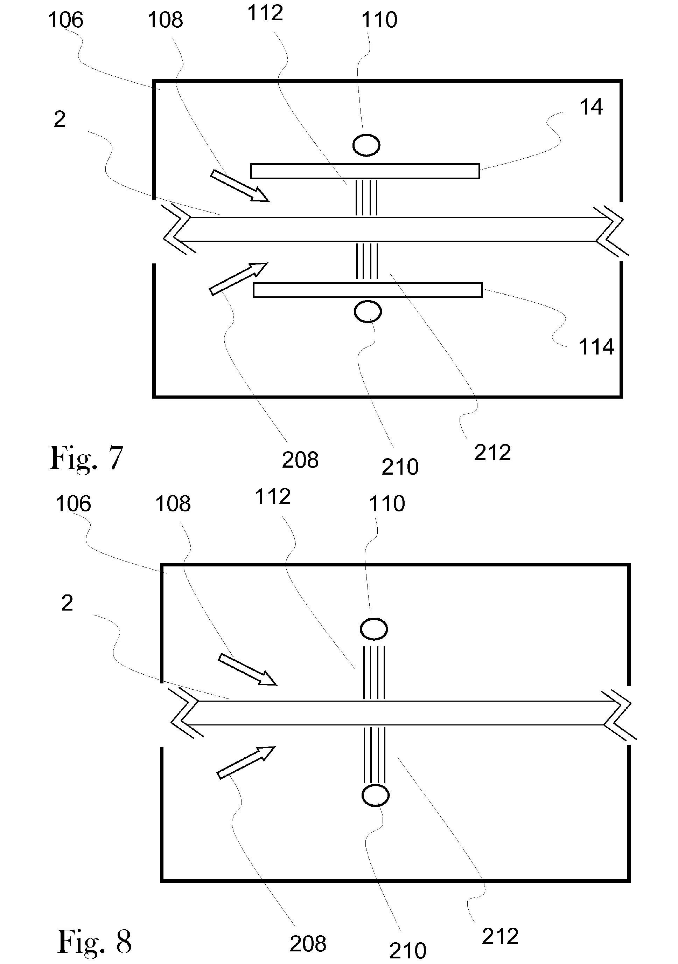

La Fig. 1 montre une chambre fermée (206) conçue pour un procédé de dépôt de couche en discontinu, sur des volumes de verre séparés. Dans ce cas, un ou deux dispositifs de fermeture (132) permettent soit de travailler à pression atmosphérique soit de travailler à des pressions s'écartant nettement de la pression atmosphérique (typiquement, entre 10⁻¹ Pa et 110 kPa) (dans le cas de l'installation représentée à la Fig. 7, il est nécessaire d'avoir recours à des dispositifs d'extraction puissants pour s'écarter de la pression ambiante). Suivant la technique CVD bien connue, un mélange réactif (108, 208) est introduit dans la chambre (206). Dans le cas d'un procédé fonctionnant à pression réduite, on peut avoir recours à des réactifs (108, 208) ayant des tensions de vapeur plus faibles et/ou qui présentent un caractère plus toxique sans mettre en danger pour autant la santé des travailleurs.

A la différence de ce qui se passe dans un procédé classique, l'introduction des mélanges réactifs se fait de part et d'autre du substrat. Comme représenté sur la Figure 1, un choix judicieux des caractéristiques permet de travailler simultanément sur les deux faces d'un volume de verre 2, en y déposant même, le cas échéant, des couches de natures différentes. On a en effet la possibilité, en usant d'artifices divers (séparation physique ou appareillage d'extraction disposé de façon adéquate) d'introduire des substances réactives différentes (108, 208) de part et d'autre du volume de verre 2 dans deux zones de plasma (112, 212). Ces deux zones de plasma sont localisées entre le volume de verre (2) et deux électrodes (110, 210) disposées dans la chambre (6) de part et d'autre du volume de verre. En outre, la distance entre le substrat à revêtir 2 et les deux électrodes (110, 210) est modulable et peut être ajustée en fonction des critères du dépôt souhaité.
Les possibilités liées à la génération d'un plasma de part et d'autre d'un substrat par le moyen d'une seule décharge sont multiples. En effet, le nombre d'applications d'un substrat traité sur les deux faces va toujours croissant. Par ailleurs, le fait de générer deux couches simultanément dans la même enceinte permet d'économiser non seulement du temps, mais également de libérer de l'espace au sol, ce qui est toujours un facteur avantageux.

Comme il a été dit plus haut, afin de générer un plasma, deux électrodes sont disposées dans la chambre 206. Ces électrodes (110, 210) s'étendent suivant un axe perpendiculaire au sens de défilement de la feuille de verre 2. Une haute tension à haute fréquence étant appliquée entre ces électrodes (110, 210) on assiste à la génération de plasmas (112, 212) (représenté schématiquement par un halo), dans lequel les réactifs- éventuellement différents- introduits dans la chambre de part et d'autre du substrat puisent l'énergie nécessaire, rendant possible le dépôt simultané sur les deux faces de la feuille de verre d'une grande variété de composés. La tension est préférentiellement comprise entre 1,000 et 200,000 V pic à pic, et de façon plus préférentielle entre 5,000 et 100,000 V pic à pic, et de façon encore plus préférentielle entre 10,000 et 40,000 V pic à pic. La fréquence est préférentiellement comprise entre 10 KHz et 1,000 KHz, et de façon plus préférentielle entre 20 KHz et 400 KHz, et de façon encore plus préférentielle entre 50 KHz et 200 KHz.

Afin de réduire le risque éventuel de formation d'arcs électriques directement entre les deux électrodes, une barrière diélectrique (14, 114) peut être disposée dans la chambre entre les emplacements des deux électrodes (110, 210). Pour accroitre encore l'énergie disponible pour la réaction, la feuille de verre 2 peut se trouver à haute température. L'énergie thermique ainsi disponible vient s'additionner à l'énergie fournie par le plasma favorisant ainsi le dépôt de couche de la composition souhaitée.

Le problème qui se pose généralement dans ce type de procédé, dès lors que l'on veut le faire passer du stade expérimental à la production industrielle, est la faiblesse du rendement obtenu au regard de l'énergie dépensée pour la génération du plasma. En conséquence, il faut améliorer ce rendement pour rendre le procédé non seulement énergétiquement rentable, mais également permettre au procédé de générer suffisamment d'énergie active pour obtenir des taux de dépôt élevés tout en améliorant les propriétés des couches déposées. Cela est d'autant plus vrai dans le cas présent que la présence de deux intervalles agissant comme des capacités en série diminue a priori le courant de décharge Par conséquent, il est nécessaire de disposer d'une installation permettant d'atteindre de fortes puissances tout en gardant un bon rendement.

On a donc entamé une étude poussée de tous les facteurs intervenant au niveau énergétique, ce qui a permis de réduire très schématiquement l'installation en cause à deux schémas équivalents tels que représentés aux Fig. 2 et 3. Le schéma équivalent d'une telle installation est évidemment plus complexe que dans une installation classique (où on ne peut déposer qu'une couche à la fois).

La Fig. 2 est un schéma équivalent très simplifié de l'installation avant l'amorçage. Une haute tension étant appliquée entre les électrodes (110, 210). L'installation de décharge dans la chambre 206 se résume essentiellement à une addition de capacités en parallèle et en série, à savoir Cp (capacité parasite en parallèle avec une résistance parasite Rp), Cd (capacité du ou des diélectriques), Cv (capacité du verre), Cg₁ et Cg₂ (capacité du gaz).

La Fig. 3 représente le même schéma lorsque le plasma est généré. A ce moment, Cg₁ et Cg₂ sont shuntés par des résistances Rg₁ et Rg₂ qui représentent la résistance des deux zones de plasma.

En l'absence de décharge (c'est-à-dire tant que la tension appliquée entre les électrodes est inférieure à la tension d'amorçage, les valeurs de Rg₁ et Rg₂ sont extrêmement élevées et le courant total fourni par la source est pratiquement uniquement capacitif, la partie réactive étant essentiellement fonction de la perte diélectrique dans l'isolant des électrodes et du substrat. Au cours de la décharge, les courants « utiles » Ig₁ et Ig₂ passant dans les décharges restent toujours faibles au regard des composantes capacitives. L'exploitation de la source de tension est donc limitée, la puissance fournie étant dissipée dans la production d'un courant réactif très important, alors que seule la composante active, fournissant la puissance wattée à la décharge (Pw=Rg x Ig²), est utile.

On a donc songé, afin de compenser le manque de puissance wattée, à placer, en parallèle de l'installation, une self L jouant le rôle de « réservoir énergétique », qui permet de générer un courant en opposition de phase par rapport à l'énergie absorbée par la charge capacitive, ce qui permet une restitution pratiquement totale de l'énergie mise en jeu. On obtient donc un schéma équivalent tel que représenté à la Fig. 4.

On remarquera toutefois que ce type de compensation n'est pas similaire à la compensation obtenue par exemple en mettant une self en parallèle à une ligne de distribution de courant. En effet, on n'a pas ici affaire à une composante capacitive fixe, comme c'est le cas dans un réseau de distribution, mais à une charge éminemment variable en fonction de la fréquence (on parle ici de Kilohertz), de l'épaisseur du substrat, des réactifs introduits dans la chambre (qui font varier les propriétés électriques et diélectriques du gaz et du plasma, etc.). En conséquence, il est nécessaire de disposer d'un type de self tout à fait particulier, capable non seulement de supporter les conditions de charge engendrées dans une installation de grande puissance, sous haute tension, bien sûr, mais également sous haute fréquence, et présentant également la possibilité d'être ajustée de façon relativement fine en fonction des conditions imposées lors de chaque type de fabrication. En effet, la charge résultante variera notamment en fonction des différents paramètres du procédé comme par exemple, la nature des réactifs, l'épaisseur du verre, les gaps gazeux... Les gaps gazeux sont préférentiellement compris entre 0.5 mm et 100 mm, et de façon plus préférentielle entre 1 mm et 20 mm, et de façon encore plus préférentielle entre 3 mm et 6 mm.

Différents essais sur la possibilité de mise en pratique concrète du procédé de l'invention ont mis en lumière une conséquence avantageuse et inattendue de ce procédé.

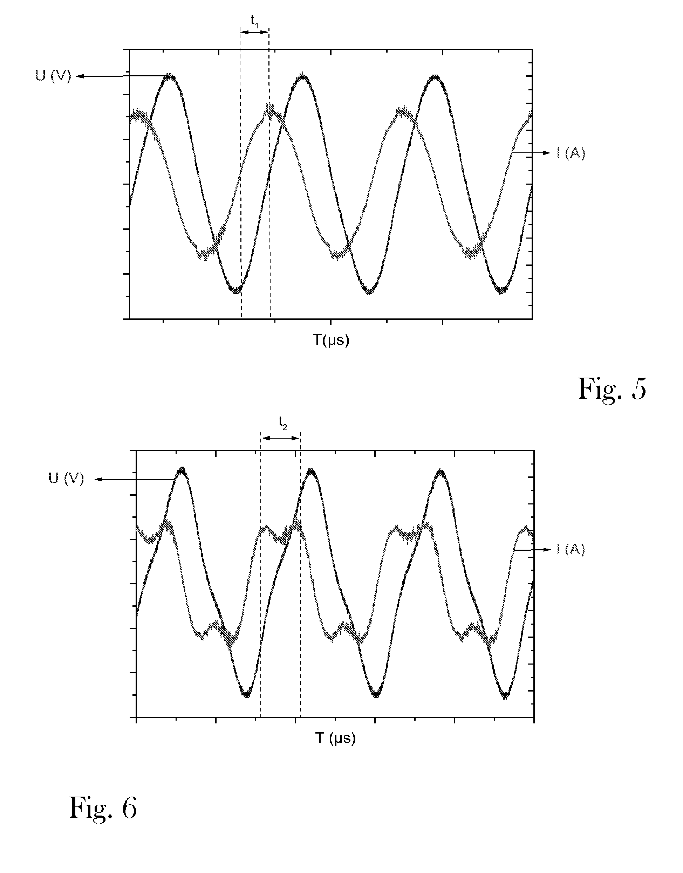

En se référant à la Fig.5, on voit qu'un autre phénomène est responsable en partie du médiocre rendement d'une installation de dépôt de couche sous plasma DBD : lorsqu'on applique une haute tension HF, pour chaque demi-période, une décharge ne peut être maintenue amorcée que pendant le laps de temps T1 où la tension appliquée est supérieure à une tension d'amorçage V1. Cet intervalle de temps est intimement lié aux paramètres décrits ci-dessus. Ce phénomène se répète évidemment à chaque demi-période. Le rendement du procédé se trouve donc limité par le rapport entre T1 et la longueur d'une demi-période.

Suivant la loi de Fourier, si une source alimente un dipôle non linéaire, le courant résultant ne sera pas linéaire et prendra une forme complexe que l'on peut décomposer en une superposition de plusieurs courbes, soit celles d'une fréquence « fondamentale » et d'une somme d'harmoniques.

En l'occurrence, on a constaté que l'interposition d'une self dans le circuit donne lieu à une déformation de la courbe de passage du courant dans le plasma, comme montré à la Fig.6. Cette courbe peut être décomposée suivant le principe des séries de Fourier en une fondamentale et une série d'harmoniques dont les plus significatives par leur amplitude sont les harmoniques impaires 3 et 5. Comme on peut le remarquer, la courbe de passage du courant présente une sorte de « plateau » durant un intervalle de temps T2, de longueur bien supérieure à l'intervalle T1 observé sur la courbe de la Fig. 5. La longueur de cet intervalle peut être optimisée en jouant sur les caractéristiques du circuit, et notamment sur la fréquence et sur la valeur de l'inductance L. En conséquence, dans l'installation de l'invention, en interposant une self ajustable de caractéristiques adéquates, on obtient, toutes choses étant par ailleurs égales, non seulement une augmentation de la puissance active, mais également un temps de décharge plus long, et en conséquence un rendement énergétique bien meilleur. La puissance active est augmentée de façon préférentielle d'au moins 10% et de façon plus préférentielle d'au moins 25%, et de façon encore plus préférentielle d'au moins 50%. Le temps de décharge est augmenté de façon préférentielle d'au moins 15% et de façon plus préférentielle d'au moins 30%, et de façon encore plus préférentielle d'au moins 60%. On notera par ailleurs que pour déterminer la valeur « optimale » de la self, il faut tenir compte de l'inductance propre du circuit d'alimentation (qui comprend un transformateur), dont la valeur n'est pas forcément négligeable. Le circuit d'alimentation ayant sa propre fréquence de résonance, la valeur de L pourra, dans certaines conditions, être fortement réduite.

Parmi les avantages du procédé tel que décrit, on peut relever les suivants :
- du fait de l'augmentation du rendement du dépôt, on peut réduire la quantité de réactifs chimiques utilisée. En conséquence, outre une diminution des coûts de production, et de l'impact environnemental, on constate un moindre encrassement des installations, ce qui génère un surcroît d'économies.
- une augmentation de la vitesse de dépôt, qui a pour corollaire une diminution du temps de traitement. En conséquence, il est possible de traiter en continu des substrats se déplaçant à plus grande vitesse. Inversement, on peut réduire la largeur de la chambre de traitement, d'où un gain de place non négligeable. Enfin, on a accès à la possibilité d'obtenir en une seule passe des couches bien plus épaisses, ce qui peut se révéler avantageux du point de vue notamment de propriétés de ces couches.
- on constate une meilleure décomposition des précurseurs lors des réactions engendrées au sein du plasma. En conséquence, on évite la présence de résidus organiques dans les couches. En outre, les dépôts seront plus denses et mieux cristallisés, d'où une amélioration des propriétés tant optiques que mécaniques des couches générées.
- il est également possible d'augmenter la variété des espèces déposées en couche sur le substrat, toujours avec un moindre impact environnemental.

Il va de soi que ce qui a été décrit plus haut pour une installation portant sur des substrats discontinus, tels que des volumes de verre prédécoupés (l'installation peut par exemple être intégrée dans une ligne de dépôt de couche par « sputtering magnétron ») s'applique mutatis mutandis à une installation intégrée dans une ligne de verre en continu suivant le procédé de « verre flotté », comme représenté sur la figure 7. L'installation est alors placée dans la galerie de recuisson. Dans ce cas, la température du substrat peut être variée entre 20°C et 600°C. La chambre 106 étant alors de type ouvert, il est nécessaire de disposer également de puissants moyens d'extraction, qui éliminent les résidus de pyrolyse et les poussières générées par le procédé de dépôt. A noter que l'installation telle que représentée sur la figure 7 peut également être intégrée dans une ligne industrielle de trempe du verre.

La Fig. 8 est une variante de l'installation présentée sur la figure 7. Si le substrat est isolant, il est possible de s'affranchir de diélectriques supplémentaires (14, 114).

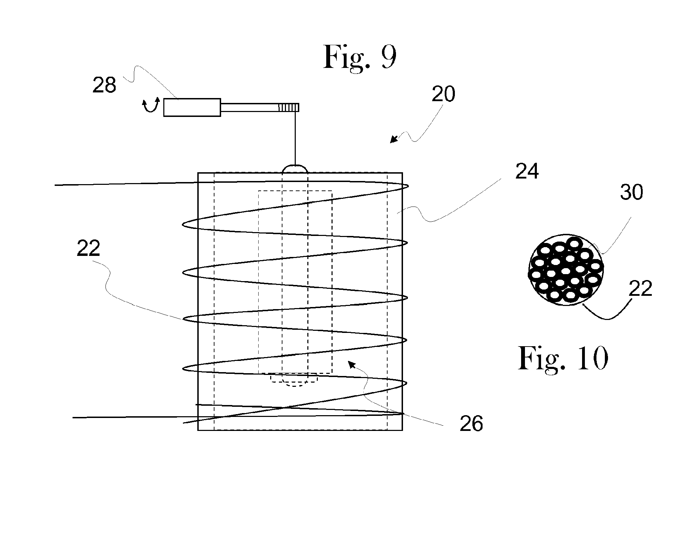

La Fig. 9 est une représentation simplifiée d'une forme de réalisation de la self de compensation 20 de l'installation de l'invention. Cette self 20 est composée essentiellement d'un bobinage 22 enroulé autour d'un mandrin 24. La tension à ces bornes pouvant être de 60 kV, le choix du matériau utilisé pour le mandrin, support du bobinage, est très important. Avantageusement l'Acculon a été retenu. Un noyau plongeur 26, soigneusement isolé et relié mécaniquement à un dispositif de positionnement 28 géré par un système de contrôle, est disposé à l'intérieur de ce mandrin 24. Vu les conditions d'utilisation particulières auxquelles cette self doit faire face en régime, il a été fait appel à une série d'innovations dans sa réalisation pratique. Ainsi, le bobinage 22 est réalisé avec un faisceau de fils de cuivre 30 (voir Fig.10), isolés, afin d'augmenter la section de passage du courant HF (en prenant en compte l'effet pelliculaire) et également pour réduire l'échauffement. Ainsi, il est possible de diviser le courant HF total par 50 en réalisant un faisceau de conducteur de 50 brins isolés entre eux. Le pas de bobinage est fixé de sorte que le risque d'amorçage entre spire soit aussi réduit que possible. Un bobinage en une seule couche est donc préférable, bien qu'il ait pour conséquence un encombrement important du dispositif dans son ensemble. L'ajustement de la position du noyau magnétique 26, donc de la valeur de la self 20, est télécommandé afin que cette manoeuvre soit rendue possible sans danger pour l'opérateur.

Il apparaîtra évident pour l'homme du métier que la présente invention n'est pas limités aux exemples illustrés et décrits ci-dessus. L'invention comprend chacune des caractéristiques nouvelles ainsi que leur combinaison. La présence de numéros de référence ne peut être considérée comme limitative. L'usage du terme « comprend » ne peut en aucune façon exclure la présence d'autres éléments autres que ceux mentionnés. L'usage de l'article défini « un » pour introduire un élément n'exclut pas la présence d'une pluralité de ces éléments. La présente invention a été décrite en relation avec des modes de réalisations spécifiques, qui ont une valeur purement illustrative et ne doivent pas être considérés comme limitatifs.

## Revendications

1. Un procédé pour le dépôt simultané sur les deux faces d'un substrat **caractérisé en ce qu'**il comprend les opérations suivantes :
- introduire ou faire défiler un substrat dans une chambre de réaction (106, 206) dans laquelle sont placées, de part et d'autre du substrat, au moins deux électrodes (110, 210), au moins une barrière diélectrique (14, 114) étant placée entre au moins une des faces de substrat et ces au moins deux électrodes (110, 210);
- engendrer une tension électrique à haute fréquence de valeur telle qu'elle entraîne la génération d'un plasma (112, 212) de part et d'autre du substrat entre les au moins deux électrodes (110, 210);
- introduire dans la chambre de réaction (106, 206), de part et d'autre du substrat, un mélange (108, 208) dont la composition est telle qu'au contact du plasma, il se décompose et engendre des espèces aptes à se déposer en couche sur la face correspondante du substrat ;
- maintenir le substrat (2) dans la chambre durant un laps de temps suffisant pour obtenir sur chacune de ses faces une couche d'une épaisseur souhaitée.

2. Procédé selon la revendication 1, **caractérisé en ce que** la composition des mélanges introduits dans la chambre de réaction (106, 206), de part et d'autre du substrat, est identique.

3. Procédé selon la revendication 1, **caractérisé en ce que** la composition des mélanges introduits dans la chambre de réaction (106, 206), de part et d'autre du substrat, est différente et engendre des espèces aptes à se déposer en couche de natures différentes sur la face correspondante du substrat.

4. Procédé selon l'une quelconque des revendications 1 à 3, **caractérisé en ce que** les mélanges introduits dans la chambre de réaction (106, 206), de part et d'autre du substrat sont confinés dans deux zones distinctes par des barrières mécaniques et/ou par des dispositifs d'aspiration et/ou de refoulement.

5. Procédé selon l'une quelconque des revendications précédente, **caractérisé en ce qu'**il comprend en outre les opérations suivantes :
- mettre en service une inductance ajustable (L) disposée en parallèle avec l'inductance propre de l'installation engendrant la tension électrique, de façon à réduire le déphasage entre la tension et le courant engendré ;
- adapter la tension et/ou la fréquence fournies par le circuit générateur et/ou la valeur de l'inductance ajustable (L) au début ou en cours de procédé, de façon à obtenir des caractéristiques de réaction optimales ;

6. Procédé selon la revendication 5, **caractérisé en ce qu'**il comprend en outre l'opération suivante :
- adapter la tension et/ou la fréquence fournies par le circuit générateur et/ou la valeur de l'inductance ajustable (L) de façon à favoriser la production d'harmoniques prolongeant le temps durant lequel la tension reste supérieure à la valeur de maintien de la décharge électrique.

7. Procédé selon la revendication 6, **caractérisé en ce que** l'on favorise essentiellement les harmoniques d'ordre 3 et 5

8. Procédé selon l'une quelconque des revendications précédentes, **caractérisé en ce qu'**il comprend en outre l'opération suivante : faire varier la position et/ou la configuration de l'au moins une électrode (110, 210) de façon à obtenir des caractéristiques de réaction optimales.

9. Procédé selon l'une quelconque des revendications précédentes **caractérisé en ce qu'**il comprend en outre l'opération suivante : - amener l'atmosphère régnant dans la chambre (106, 206) à une pression déterminée.

10. Procédé selon l'une quelconque des revendications précédentes, **caractérisé en ce que** la chambre est ouverte (106) et comprend une zone d'entrée et une zone de sortie pour le substrat.

11. Procédé selon l'une quelconque des revendications 1 à 9, **caractérisé en ce que** la chambre est fermée (206).

12. Procédé selon l'une quelconque des revendications précédentes, **caractérisé en ce que** le substrat (2) est isolant et constitue lui-même au moins une des barrières diélectriques (14, 114).

13. Procédé selon l'une quelconque des revendications 1 à 11, **caractérisé en ce que** le substrat (2) est conducteur et forme lui-même l'une des électrodes.

14. Une installation de dépôt de couches sur un substrat (2) comprenant une chambre (106, 206), des moyens de transport et des moyens de support pour introduire un substrat dans la chambre, une alimentation électrique à haute tension et à haute fréquence reliée à au moins deux électrodes (110, 210) disposées de part et d'autre du substrat (2), au moins une barrière diélectrique (14, 114) disposée entre les au moins deux électrodes(110, 210), des moyens de régulation et de contrôle de l'alimentation électrique, des moyens d'introduction de substances réactives (108, 208) dans la chambre (106, 206), des moyens d'extraction de substances résiduelles, **caractérisée en ce qu'**un plasma est généré dans deux zones distinctes disposées de part et d'autre du substrat, de façon telle qu'une couche est déposée sur chacune des faces de ce substrat simultanément.

15. Une installation de dépôt suivant la revendication 14 **caractérisée en ce qu'**une inductance ajustable (L) est placée en parallèle avec l'inductance du circuit d'alimentation, les caractéristiques de cette inductance ajustable (L) étant telles qu'elle permet de moduler le déphasage entre la tension générée entre les électrodes (110, 210) et le courant total fourni par la source haute tension.

16. Une installation de dépôt suivant l'une quelconque des revendications 14 ou 15 **caractérisée en ce que** les moyens de régulation de l'alimentation électrique et les moyens de contrôle de l'inductance (L) sont couplés de façon à permettre la génération d'harmoniques prolongeant le maintien de la valeur de la tension entre les électrodes (110, 210) à une valeur supérieure à celle de maintien de la décharge électrique.

17. Une installation de dépôt suivant l'une quelconque des revendications 14 à 16 **caractérisée en ce que** la chambre (106) est ouverte à ses deux extrémités.

18. Une installation de dépôt suivant l'une quelconque des revendications 14 à 16 **caractérisée en ce que** la chambre (206) est fermée à ses deux extrémités.

19. Une installation de dépôt suivant l'une quelconque des revendications 14 à 17 **caractérisée en ce qu'**elle est intégrée dans une ligne de production de verre flotté, la chambre (106) étant placée dans la galerie de recuisson, les moyens de support du substrat comprenant au moins un rouleau.

20. Installation de dépôt suivant l'une quelconque des revendications 14 à 17 **caractérisée en ce qu'**elle est intégrée dans une ligne de trempe.

21. Installation de dépôt suivant l'une quelconque des revendications 14 à 16 et 18 **caractérisée en ce qu'**elle est intégrée dans une ligne de dépôt travaillant à basse pression.

22. Une installation de dépôt suivant l'une quelconque des revendications 14 à 21 **caractérisée en ce que** l'inductance comprend :
- un bobinage (22) constitué d'un faisceau d'éléments conducteurs (30) isolés les uns par rapport aux autres, enroulé autour d'un mandrin (24) ;
- un noyau magnétique plongeur (26) disposé à l'intérieur de ce mandrin (24), isolé de ce mandrin (24);
- un dispositif de positionnement (28) relié au noyau plongeur (26) ;
- une connexion isolante reliant le noyau plongeur (26) et le dispositif de positionnement ;
- un système de contrôle apte à agir sur le dispositif de positionnement, de façon à ajuster la position du noyau magnétique plongeur (26) par rapport au mandrin (24).
